Europäisches Patentamt

(19) European Patent Office

Office européen des brevets

(11) Publication number: **0 149 330**
**B1**

(12) **EUROPEAN PATENT SPECIFICATION**

(45) Date of publication of patent specification: **26.04.89**

(21) Application number: **84308485.6**

(22) Date of filing: **06.12.84**

(51) Int. Cl.⁴: **H 01 L 21/306, H 01 L 29/52,**
**G 01 N 27/00**

(54) ISFET Sensor and method of manufacture.

(30) Priority: **08.12.83 US 559513**

(43) Date of publication of application:
**24.07.85 Bulletin 85/30**

(45) Publication of the grant of the patent:
**26.04.89 Bulletin 89/17**

(84) Designated Contracting States:
**DE FR GB IT**

(56) References cited:
**EP-A-0 063 455**
**FR-A-2 400 258**
**GB-A-1 492 465**
**GB-A-2 103 014**
**US-A-4 141 021**

**Ching-chang Wen: Grad. Diss. Univ. of
Pennsylvania, 1979 pp. 19; 36.**

**IEEE Trans. vol. CHNTS. No. 4 (1982) pp. 520,
521**

(73) Proprietor: **GENERAL SIGNAL CORPORATION**
**PO Box 10010 High Ridge Park**
**Stamford Connecticut 06904 (US)**

(72) Inventor: **Baxter Ronald D.**
**3050 South Cloverly Drive**
**Furlong Pennsylvania (US)**

(74) Representative: **Baillie, Iain Cameron et al**
**c/o Ladas & Parry Isartorplatz 5**
**D-8000 München 2 (DE)**

Courier Press, Leamington Spa, England.

## Description

This invention relates to chemical or electrochemical sensors based on Si FET technology and particularly relates to the construction of such devices for the measurement of hydrogen ions (pH) and other ion activity in solution. Such devices are known as ISFET's (ion selective field-effect transistors) and are similar to conventional insulated gate FET's except that the metal gate electrode is removed and the gate region is covered by a suitable insulator film. This insulating layer acts as the ion selective, sensitive membrane.

In its use as a pH sensor, the ISFET must be immersed in an electrolyte which, from the standpoint of the normal electrical connections made to the front side, is a very hostile environment. It is, therefore, desirable to design the ISFET so as to minimize contact between the electrical circuitry and the electrolyte solution so that the integrity, stability, and reliability of the device is maintained.

In the past many attempts have been made to achieve the desired isolation between the environment to which the ISFET is exposed and its associated electrical circuitry. These attempts have generally been in biomedical applications and have involved approaches as locating the metallized source and drain bonding pads several millimeters from the gate region with electrical access being accomplished through diffused silicon conductors. In those devices the metallized surface forming the pads is protected from the environment by the use of epoxies or silicone rubber. This approach typically results in a long, slender probe which may be 150 microns thick by 500 microns wide by 600 microns long. While such probes may be suited for medical applications they have disadvantages in laboratory and industrial applications, for they present higher lead impedances due to the relatively long path of the conductors leading from the gate region. Also, they do not have the durability and reliability necessary to operate under the more extreme environments encountered outside the medical field.

As indicated above, the prior art devices typically use contacts on the front side (the chemically or electro-chemically responsive side) of the ISFET. Thus, protection is required for the circuit leads of circuit elements to isolate them from the environment. In some cases this protection has been attempted by providing contact from the back of the device. This has been done, for example, by making contact with the source and drain by way of holes which have been laser machined all the way through the device or by migrating aluminum through the device. These methods described in "Gate Controlled Diode for Ionic Concentration Measurements": Ching-Chang wen, Graduate Dissertation, University of Pennsylvania, 1979, Pages 19 and 36 and "Fabrication of Through-Wafer via Conductors in Si by Laser Photochemical Processing": Daniel J. Ehrlich, Donald J. Silversmith, Robert W. Mountain, and Jeff Tsao, IEEE Trans. on Components, Hybrids, and Manufacturing Technology, Vol. CHNT-5, No. 4 520 and 521 (1982), all have the disadvantage of producing either a disrupted front surface or a region which is not mechanically strong. In this connection, it should be pointed out that a planar front surface is desirable in order to avoid susceptibility to contamination which can cause a fouling of the gate membrane.

According to the present invention there is provided a method of providing electrical contact to a source region and drain region of an ISFET having a silicon substrate with a crystallographic orientation (100) characterized by the steps of providing an etch stopping characteristic to the source and drain regions, etching with an orientation dependent etch individual holes from the back of the substrate up to the source and drain regions, producing an isolation region in the sidewalls of said holes, and metallizing over said sidewalls and onto the back to provide the electrical contacts for said source and drain regions on the back of said ISFET.

According to a further aspect of the invention there is provided an ISFET ion selective sensor characterized by an N-type silicon substrate with a (100) crystallographic orientation, P+ source and drain regions, and an external source and drain contact structure having individual holes etched by an orientation dependent etch from the back of the ISFET up to the source and drain regions, P+ regions in the sidewalls of said holes to provide electrical isolation of the surface of said sidewalls from the substrate and a metallized surface deposited on the sidewalls of the holes and extending to separate associated contact areas on the back.

There is provided an ISFET structure such that external electrical contact to the source and drain regions is made through individual holes etched from the back up to the source and drain regions with sidewall isolation being provided in the holes and metallization covering the surface of said sidewalls and extending to contact pads on the back of the ISFET. This ISFET is manufactured by using a silicon substrate having a crystallographic structure with a (100) orientation. An orientation dependent etch is used to etch the holes to the source and drain regions where the presence of an etch stop halts the etching process. A doped region is then created in the sidewalls of the holes to provide the isolation from the substrate and the metallization is then laid on the sidewalls to provide the external contacts.

Fig. 1 is a cross section of an ISFET made in accordance with this invention.

Figs. 2A through 2J are cross section drawings showing the steps in the construction of the ISFET of this invention.

Fig. 3 is a cross section of a probe holding the ISFET of the invention.

Fig. 4 is a cross section of a header assembly for holding the ISFET of the invention in a probe.

Fig. 5 is a bottom view of the header assembly of Fig. 4.

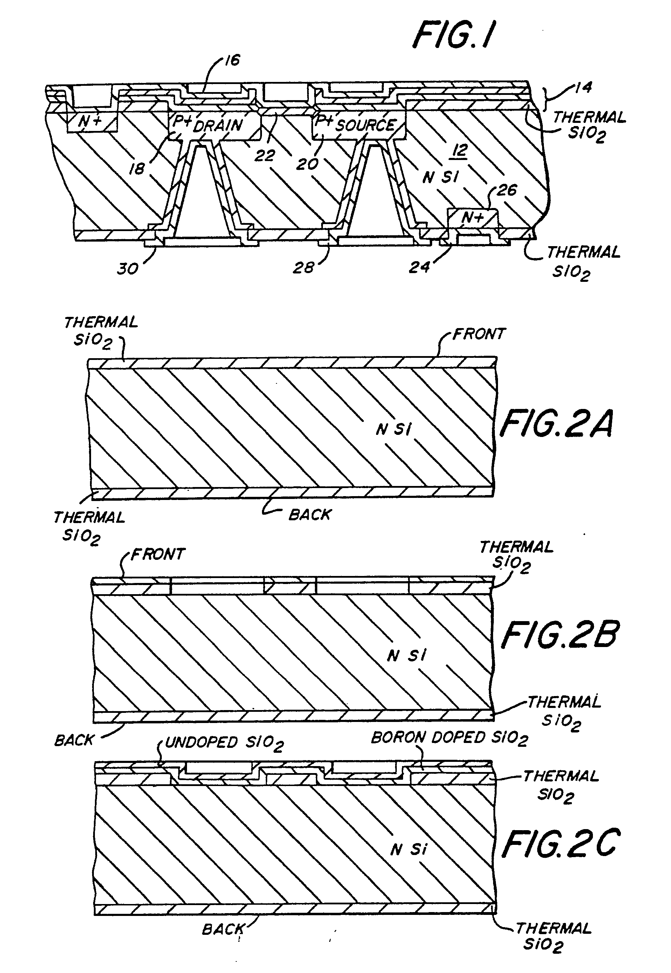

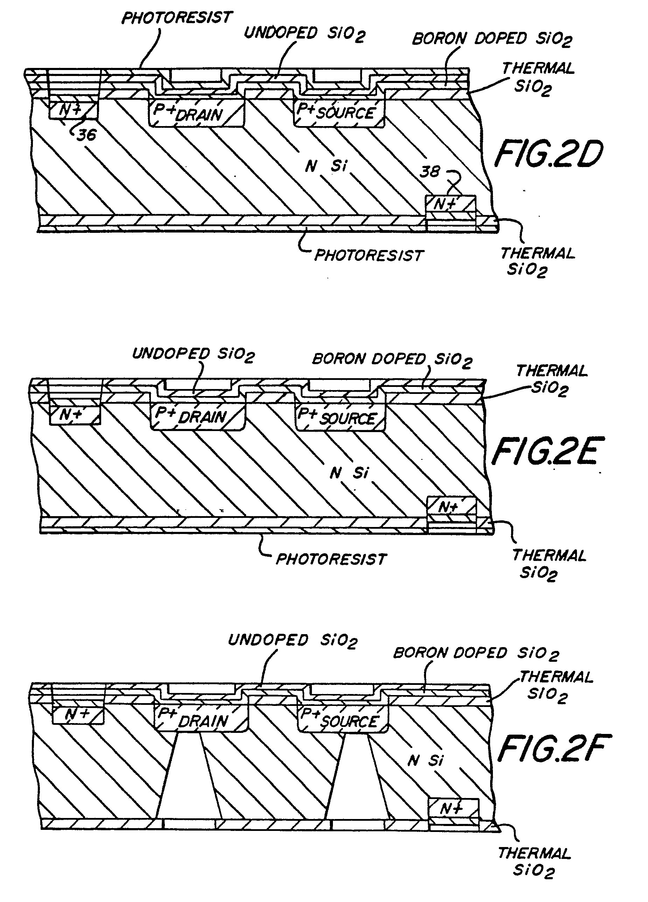

There is shown in Fig. 1 a cross-section of an ISFET chip 10 having the desired structure as obtained when manufactured in accordance with this invention. The substrate 12 is a silicon crystal having an orientation of (100), shown as N-Si. On the front side the substrate is successively coated with a number of oxides 14, more fully described later, and an ion sensitive membrane 16, such as silicon nitride or aluminum oxide. The substrate is doped to have a P+ drain region 18 and a P+ source region 20. In the area between the source and drain there is a window in the field oxide where a gate oxide 22 has been grown under the ion sensitive membrane. On the back side of the substrate 12 there is a field oxide coating which is windowed to provide the substrate contact 24 to an N+ region 26. Other windows are provided for the source contact 28 and the drain contact 30. These two contacts are made through holes etched in the back of the ISFET so as to form the pyramidal shaped holes shown in Fig. 1. The sidewalls of these holes are provided with an isolating P+ region for isolating the substrate, as shown in Fig. 1. Over the isolating P+ region of the sidewalls a metallization is deposited to provide the electrical contact from the back of the ISFET to both the source and drain. This metallization is carried from the sidewalls to the back to provide contact areas or pads for wire bonding the circuit leads necessary to incorporate the ISFET chip into a probe.

The construction of the ISFET of this invention generally follows standard long-channel FET technology with the exception of the means provided for making electrical connection to the source and drain region. For these connections, the present invention is utilized to avoid the problems pointed out above. Thus, the electrical contacts are provided in such a way that the front surface of the ISFET is not disturbed or weakened. As will be fully described in the subsequent description detailing the method of manufacturing the ISFET of this invention, the etching of the via holes from the back for the source and drain contacts is stopped at the source and drain boundaries by an etch stop. A preferred method of performing this etch stopping action has been found to be by doping the source and drain regions to have a high concentration of boron. In this connection the inventor has used a boron concentration greater than $5 \times 10^{19}$ cm$^{-3}$ with the etchant Ethylene-diamene-pyrocatechol-water.

The preferred process for manufacturing an ISFET in accordance with this invention is set forth below.

1. Start with an N type wafer of silicon with a crystallographic orientation (100), a resistivity of about 3 ohm-cms, a diameter of 5.08 cm (2 inches), and a thickness of 0.15 mm (6 mils) (polished both sides).

2. Grow a field oxide in wet oxygen on both back and front to a thickness of 700 nm (7,000 Å), as shown in Fig. 2A.

3. Etch holes all the way through for registration purposes.

4. Open windows on the front in the field oxide for the source-drain diffusion step by coating with photo-resist except in the areas to be opened and then etching those areas, as shown in Fig. 2B.

5. Deposit boron doped silicon dioxide by chemical vapor deposition using silane and oxygen with $B_2H_6$ as a dopant and a source of boron. Deposit the boron doped silicon dioxide to a thickness of 250 nm (2500 Å) and cover with another 250 nm (2500 Å) of undoped silicon dioxide, as shown in Fig. 2C. In the chemical vapor deposition process use 10 percent dibromane to total hydrides.

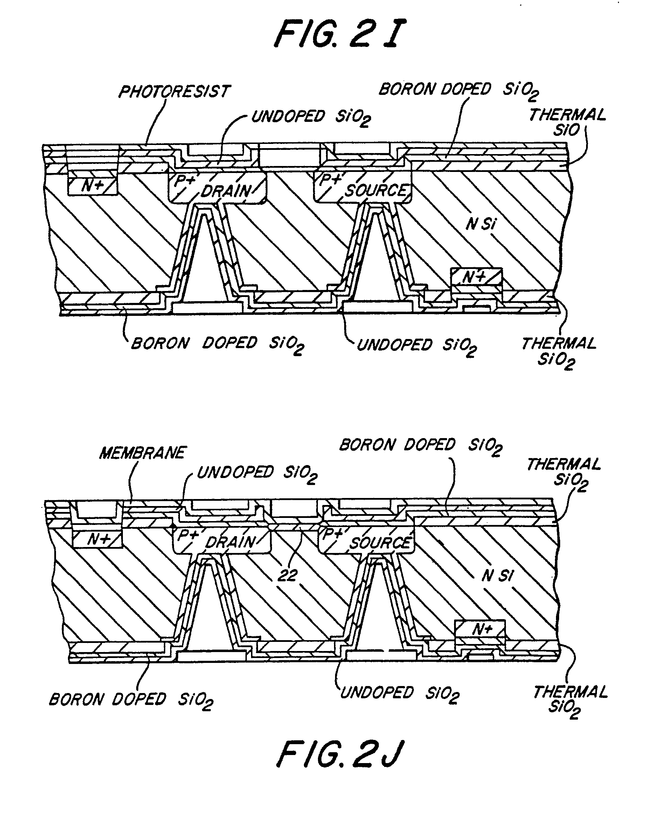

6. The drive step of the boron diffusion process is carried out at 1175°C. for 90 minutes, which gives a depth of 4—6 μ for the resulting P+ source and drain regions, as shown in Fig. 2D.

7. Etch other windows on the front for the channel stop using a photoresist and an etch to provide for the production of the N+ region 36 of Fig. 2D.

8. Etch another window on the back for the substrate contact which will be provided by the generation of the N+ region 38 of Fig. 2D.

9. Do a phosphorous diffusion on both front and back using solid sources at 950°C. for 30 minutes. This deposition is followed by a 1100°C. drive for 30 minutes. The result is the production of the N+ regions 36 and 38 of Fig. 2D.

10. Open windows in the oxide on the back opposite the source and drain regions as shown in Fig. 2E using photoresist to cover the part that is not to be etched.

11. Etch holes in the silicon substrate to provide access from the back up to the source and drain regions. Use Ethylenediamene-pyrocatechol-water as the etchant. This etch will terminate at the source and drain regions because of the boron concentration in the source and drain. This etching process produces areas of oxide which overhang the sidewalls, as shown in Fig. 2F.

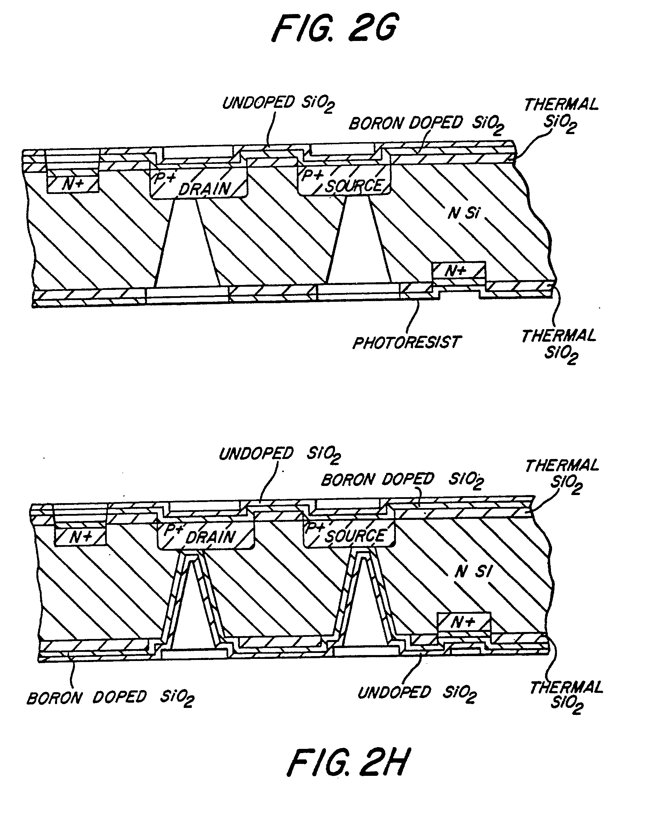

12. The overhanging areas are removed by etching, as shown in Fig. 2G.

13. Produce the N+ regions in the sidewalls of the holes to isolate the N type silicon substrate from the contacts to be formed. Thus, source and drain regions are formed in the sidewalls of the etched holes. The process for doing this is the same as for producing the source and drain regions. Thus, the boron doped silicon dioxide is layed on the back and covered by an undoped silicon dioxide, as shown in Fig. 2H.

14. Drive the diffusion into the sidewalls at 1100°C. for 30 minutes.

15. Open a window in the oxide on the front by etching, as shown in Fig. 2I, for providing the gate.

16. Grow a dry gate oxide 22, as shown in Fig. 2J.

17. Deposiit an ion sensitive membrane over the front, as shown in Fig. 2J. This membrane may, for example, be silicon nitride or aluminum oxide where the ISFET is to be used to make pH measurements.

18. Open the contact regions on the back by etching away the various oxide layers.

19. Metallize the contact areas including the sidewalls of the holes and associated areas on the back as contact pads for connection of the external circuitry to the source, drain and substrate regions, as shown in Fig. 1.

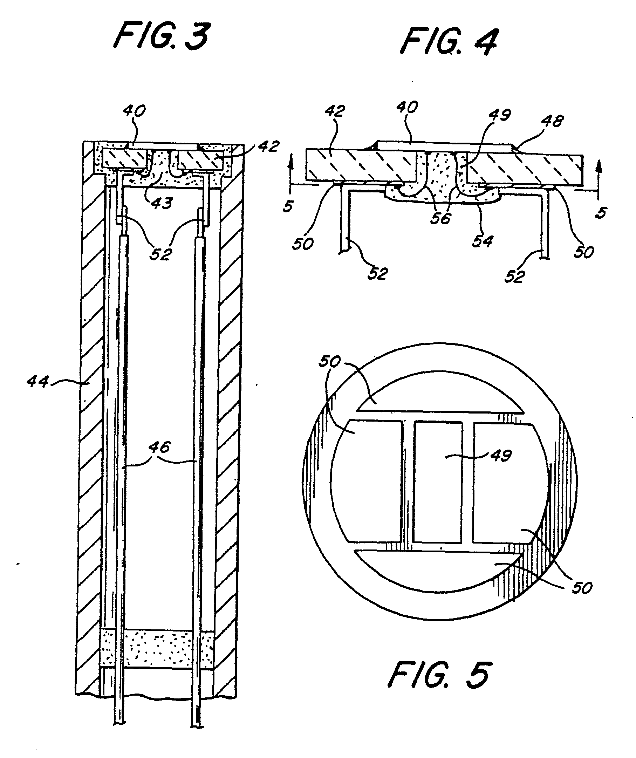

For the purpose of using an ISFET manufactured in accordance with the above process, it is necessary to mount the ISFET chip 40 in a holder or probe assembly. This probe may have the construction shown in Fig. 3, where the chip is shown mounted on a header 42. The header with its mounted chip is potted with epoxy or silicone 43 in the end of the probe body 44 with the insulated leads 46 extending along the length of the probe body with epoxy used in other areas to seal and support. The probe body may be made from a spin cast epoxy or other suitable material depending on the uses of the probe.

The mounting of the ISFET chip 40 on the header is shown in detail in Fig. 4. The ISFET chip is epoxied to the top of the header by placing epoxy 48 around the edges of the chip. The header is a circular piece of aluminum oxide or a borosilicate glass disc having a square hole 49 in the center and areas of thick film metallization 50 on the back to provide a place for bonding the lead outs 52 which will be soldered to the leads 46. The epoxy 54 fills the hole in the header and secures the electrical leads 56 to provide a rugged structure for the probe.

Fig. 5 shows a bottom view of the header itself with the areas of metallization 50 shown.

If desired the epoxy 48 holding the ISFET chip to the header can be replaced with an anodic bond if the header is made of borosilicate glass.

## Claims

1. A method of providing electrical contact to a source region and drain region of an ISFET having a silicon substrate with a crystallographic orientation of (100), comprising providing an etch stopping characteristic to the source and drain regions, etching with an orientation dependent etch individual holes from the back of the substrate up to the source and drain regions, producing an isolation region in the sidewalls of said holes, and metallizing over said sidewalls and onto the back to provide the electrical contacts for said source and drain regions on the back of said ISFET.

2. A method according to claim 1, characterized in that the source and drain regions are P+ regions, the substrate is an N-type silicon, and the isolation region is a P+ region.

3. A method according to claim 2, characterized in that the source and drain regions are provided with an etch stopping characteristic by producing them through diffusion of boron into the silicon substrate so that said regions have a boron concentration sufficient to provide the necessary etch stopping characteristic.

4. A method according to claim 3, characterized in that boron concentrations greater than $5 \times 10^{19}$ cm$^{-3}$ are produced in the source and drain regions by diffusion from a boron doped silicon dioxide layer.

5. A method according to claim 4, characterized in that the diffusion is driven at 1175°C. for 90 minutes.

6. A method according to claim 4, characterized in that the etchant used to etch the holes is Ethylenediamine-pyrocatechol-water.

7. An ISFET ion selective sensor comprising an N-type silicon substrate (12) with a (100) crystallographic orientation, P+ source (20) and drain (18) regions, and an external source and drain contact structure having individual holes etched by an orientation dependent etch from the back of the ISFET up to the source and drain regions, P+ regions in the sidewalls of said holes to provide electrical isolation of the surface of said sidewalls from the substrate, and a metallized surface deposited on the sidewalls of the holes and extending to separate associated contact areas on the back.

8. An ISFET sensor according to claim 7, further characterized by a doped N+ channel stop region in the front of said substrate, a doped N+ substrate contact region in the back of said substrate, a gate oxide grown on the front of said substrate, a field oxide coating on the front surface of said substrate with an opening in the area in front of the gate oxide, and a pH sensitive membrane covering the field oxide coating and the gate regions.

9. An ISFET sensor according to claim 7 or claim 8, characterized by the provision of mounting means including a tubular body, a circular head having the ISFET sensor mounted on one side thereof and having thick film metallization in separated regions on the other side, lead outs bonded to said metallized areas, wire connections between said metallized areas on said header and said contact areas on the back of said sensor, insulated leadwire connected to said lead outs and extending the length of the body, said header and the mounted ISFET sensor with associated lead outs and wire connections being potted in the end of said body.

## Patentansprüche

1. Verfahren zum Herstellen von elektrischen Kontakten mit einem Source- und einem Drainbereich eines ISFET, der ein Siliciumsubstrat mit der kristallographischen Orientierung (100) besitzt, wobei eine für den Source- und den Drainbereich charakteristische Ätzbegrenzung geschaffen wird, und durch orientierungsabhängige Ätzung Löcher von der Rückseite des Substrats bis zu dem Source- und dem Drainbereich geätzt werden, daß in den Seitenwandungen der Löcher ein Isolierbereich gebildet wird, und daß zum Herstellen von auf der Rückseite des ISFET vorgesehenen, elektrischen Kontakten für den Source- und den Drainbereich auf die Seitenwandungen und die Rückseite eine Metallisierung aufgetragen wird.

2. Verfahren nach Anspruch 1, dadurch gekennzeichnet, daß der Source- und der Drainbereich P+-Bereiche sind, das Substrat aus Silicium vom Typ n besteht und der Isolierbereich ein P+-Bereich ist.

3. Verafhren nach Anspruch 2, dadurch gekennzeichnet, daß der Source- und der Drainbereich mit einer Ätzbegrenzung versehen werden, indem sie durch Diffundieren von Bor in das Siliciumsubstrat derart gebildet werden, daß die Borkonzentration in den genannten Bereichen zum Erzielen der erforderlichen Ätzbegrenzung genügt.

4. Verfahren nach Anspruch 3, dadurch gekennzeichnet, daß in dem Source- und dem Drainbereich durch Diffundieren aus einer bordotierten-Siliciumdioxidschicht Borkonzentrationen über $5 \cdot 10^{19}$ cm$^{-3}$ geschaffen werden.

5. Verfahren nach Anspruch 4, dadurch gekennzeichnet, daß das Diffundieren 90 min bei 1175°C durchgeführt wird.

6. Verfahren nach Anspruch 4, dadurch gekennzeichnet, daß das zum Ätzen der Löcher verwendete Ätzmittel Ethylendiaminprocatechol-Wasser ist.

7. Ionenselektiver ISFET-Sensor mit einem n-Siliciumsubstrat (12) mit der kristallographischen Orientierung (100), mit einem P+-Sourcebereich (20) und einem P+-Drainbereich (18) und mit einer externen Source- und Drain-Kontaktstruktur mit einzelnen Löchern, die durch orientierungsabhängiges Ätzen von der Rückseite des ISFET bis zu dem Source- und dem Drainbereich geätzt worden sind, ferner mit in den Seitenwänden der Löcher vorgesehenen P+-Bereichen zum elektrischen Isolieren der Oberfläche der Seitenwandungen von dem Substrat, und mit einer metallisierten Fläche, die auf die Seitenwandungen der Löcher aufgetragen ist und sich bis zu getrennten, zugeordneten Kontaktflächen auf der Rückseite erstreckt.

8. ISFET-Sensor nach Anspruch 7, gekennzeichnet durch einen auf der Vorderseite des Substrats vorgesehenen, dotierten N+-Kanalbegrenzungsbereich, einen auf der Rückseite des Substrats vorgesehenen, dotierten, N+-Substratkontaktbereich, ein auf der Vorderseite des Substrats gezüchtetes Gattoxid, einen auf der Vorderfläche des Substrats vorgesehenen Feldoxidüberzug mit einer Öffnung in dem Bereich vor dem Gattoxid, und eine pH-empfindliche Membran, die den Bereich des Feldoxidüberzuges und des Gatts bedeckt.

9. ISFET-Sensor nach Anspruch 7 oder 8, dadurch gekennzeichnet, daß Befestigungsmittel vorgesehen werden, die einen rohrförmigen Körper umfassen, ferner einen kreisförmigen Kopfteil, auf dem auf einer Seite der ISFET-Sensor montiert ist und der auf der anderen Seite in voneinander getrennten Bereichen mit einer Dickschichtmetallisierung versehen ist, ferner durch mit den metallisierten Bereichen stoffschlüssig verbundene Anschlüsse, durch Drahtverbindungen zwischen den metallisierten Bereichen des Kopfteils und den auf der Rückseite des Sensors vorgesehenen Kontaktbereichen, und durch mit den Anschlüssen verbundene, isolierte Leitungsdrähten, die sich über die Länge des Körpers erstrecken, wobei der Kopfteil und der montierte ISFET-Sensor mit den zugeordneten Anschlüssen und Drahtverbindungen in dem Ende des Körpers vergossen sind.

**Revendications**

1. Procédé de formation d'un contact électrique vers une région de source et une région de drain d'un ISFET comprenant un substrat de silicium d'orientation cristallographique (100), comprenant les étapes consistant à conférer une caractéristique d'arrêt de gravure aux régions de source et de drain, à graver par gravure anisotrope des trous individuels à partir de la face arrière du substrat jusqu'aux régions de source et de drain, à produire une région d'isolement dans les parois latérales desdits trous, et à réaliser des méallisations sur les parois latérales et la face arrière pour former des contacts électriques pour les régions de source et de drain sur la face arrière de l'ISFET.

2. Procédé selon la revendication 1, caractérisé en ce que les régions de source et de drain sont des régions P$^+$, le substrat est en silicium de type N, et la région d'isolement est une région P$^+$.

3. Procédé selon la revendication 2, caractérisé en ce que les régions de source et de drain sont munies d'une caractéristique d'arrêt de gravure en les formant par diffusion de bore dans le substrat de silicium de sorte que ces régions ont une concentration en bore suffisante pour leur conférer la caractéristique nécessaire d'arrêt d'attaque.

4. Procédé selon la revendication 3, caractérisé en ce que des concentrations de bore supérieures à $5 \times 10^{19}$ cm$^{-3}$ sont produites dans les régions de source et de drain par diffusion à partir d'une couche de dioxyde de silicium dopée au bore.

5. Procédé selon la revendication 4, caractérisé en ce que la diffusion est réalisée à 1175°C pendant 90 minutes.

6. Procédé selon la revendication 4, caractérisé en ce que le produit d'attaque utilisé pour graver les trous est de l'éthylène-diamine-pyrocatéchol-eau.

7. Détecteur sélectif d'ions ISFET comprenant un substrat de silicium de type N (12) d'orientation cristallographique (100) des régions P$^+$ de source (20) et de drain (18), et une structure de contact externe de source et de drain comprenant des trous individuels gravés par gravure anisotrope à partir de l'arrière de l'ISFET jusqu'aux régions de source et de drain, des régions P$^+$ dans les parois latérales des trous pour assurer une isolation électrique de la surface des parois latérales par rapport au substrat, et une surface métallisée déposée sur des parois latérales des trous et s'étendant vers des zones de contact associées sur la face arrière.

8. Détecteur ISFET selon la revendication 7, caractérisé en outre par une région d'arrêt de canal dopée de type N$^+$ à l'avant du substrat, une région de contact de substrat dopée de type N$^+$

dans la face arrière du substrat, un oxyde de grille amené à croître sur la face avant du substrat, un oxyde de champ revêtant la surface avant du substrat avec une ouverture dans la zone située en face de l'oxyde de grille, et une membrane sensible au pH recouvrant le revêtement d'oxyde de champ et les régions de grille.

9. Détecteur ISFET selon la revendication 7 ou la revendication 8, caractérisé par le prévision de moyens de montage comprenant un corps tubulaire, une tête circulaire sur un côté de laquelle est monté ledit détecteur ISFET et comprenant une métallisation en couche épaisse dans des régions séparées de l'autre face, des conducteurs de sortie liés aux zones métallisées, des connexions à fils entre les zones métallisées de la tête et les zones de contact à l'arrière du détecteur, des fils d'amenée isolés connectés aux conducteurs de sortie et s'étendant le long du corps, la tête et le détecteur ISFET associé à ses conducteurs de sortie et ses connexions à fils étant encapsulés à l'extrémité dudit corps.

## FIG.1

## FIG.2A

## FIG.2B

## FIG.2C

PHOTORESIST   UNDOPED SiO₂   BORON DOPED SiO₂   THERMAL SiO₂

N⁺   P⁺DRAIN   P⁺SOURCE   N Si   38   N⁺

36

PHOTORESIST   THERMAL SiO₂

FIG.2D

UNDOPED SiO₂   BORON DOPED SiO₂   THERMAL SiO₂

N⁺   P⁺DRAIN   P⁺SOURCE   N Si   N⁺

PHOTORESIST   THERMAL SiO₂

FIG.2E

UNDOPED SiO₂   BORON DOPED SiO₂   THERMAL SiO₂

N⁺   P⁺DRAIN   P⁺SOURCE   N Si   N⁺

FIG.2F

THERMAL SiO₂

# FIG. 2G

UNDOPED SiO₂     BORON DOPED SiO₂     THERMAL SiO₂

N+    P+ DRAIN    P+ SOURCE    N Si    N+

PHOTORESIST    THERMAL SiO₂

# FIG. 2H

UNDOPED SiO₂     BORON DOPED SiO₂     THERMAL SiO₂

N+    P+ DRAIN    P+ SOURCE    N SI    N+

BORON DOPED SiO₂    UNDOPED SiO₂    THERMAL SiO₂

3

EP 0 149 330 B1

FIG. 2 I

FIG. 2J

# FIG. 3

# FIG. 4

# FIG. 5

5